(19) Europäisches Patentamt / European Patent Office / Office européen des brevets

(11) **EP 2 180 513 A1**

(12) **EUROPEAN PATENT APPLICATION**

(43) Date of publication:
**28.04.2010 Bulletin 2010/17**

(51) Int Cl.:
***H01L 27/146*** (2006.01)

(21) Application number: **08305733.1**

(22) Date of filing: **27.10.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **STMicroelectronics SA**
**92120 Montrouge (FR)**

(72) Inventors:
- **Cazaux, Yvon**
  **38100 Grenoble (FR)**
- **Vaillant, Jérôme**
  **38100 Grenoble (FR)**

(74) Representative: **de Beaumont, Michel**
**Cabinet Beaumont**
**1, rue Champollion**
**38000 Grenoble (FR)**

(54) **Near infrared/color image sensor**

(57) The invention concerns a near infrared/color photodetector made in a monolithic form in a lightly-doped substrate (50) of a first conductivity type covering a holder (52) and comprising a face on the side opposed to the holder. The photodetector comprises at least first (PHD3) and second (PHD4) photodiodes for the storage of electric charges photogenerated in the substrate (50), the second photodiode (PHD4) being adjacent to said face; and a first region (68) extending at least between the second photodiode (PHD4) and the holder (52), preventing the passage of said charges between a first substrate portion being located between said region (68) and the holder (52) and a second substrate portion (78) extending between said face and the first region (68), the first photodiode (PHD3) being adapted to store at least charges photogenerated in the first substrate portion and the second photodiode (PHD4) being adapted to store charges photogenerated in the second substrate portion (78).

Fig. 6

**Description**

**FIELD OF THE INVENTION**

The present invention relates to the structure and the operation of image sensors intended to be used in shooting devices such as, for example, cameras, camcorders or cell phones.

**BACKGROUND OF THE INVENTION**

A color image sensor generally comprises an array of photosensitive cells or pixels. When manufactured in a monolithic form, each cell comprises a photosensitive component, for example a photodiode, formed in a substrate. The color detection is achieved by providing a colored filter associated with each cell, which only lets through the light rays having a wavelength within a given range. Three types of filters corresponding to the three primary colors (red, green, blue) are generally used. The colored filters generally comprise a layer of an organometallic material or a stack of several layers of organometallic materials. An example of the distribution of the colored filters is the Bayer pattern according to which the pixels are arranged in rows and columns, forming groups of four pixels having a common corner, and wherein, for each of these groups, green filters are associated with diagonally opposite pixels and red and blue filters are associated with the other diagonally opposite pixels. A drawback with the colored filters commonly used in the manufacturing of semiconductor devices is that they also let through light rays having a wavelength superior to approximately 800 nm. It is then necessary to further provide, for each pixel, a filter which only lets through light rays having a wavelength inferior to about 750 nm, to avoid interference of the signal provided by each pixel caused by infrared light rays. The manufacture of a filter for stopping infrared light, integrated alongside the colored filters, is rather complex and expensive since it usually requires manufacturing an interference filter including several superposed layers. It is therefore often preferred to use a filter for stopping infrared light which is separated from the image sensor, for example placed near the optical devices which focus the light rays towards the image sensor.

There also exist infrared image sensors which detect infrared light rays and, more precisely, near infrared light rays. These sensors can have the same general structure as color image sensors except that they do not have filters since all the light that reaches the image sensor is usually used to provide a signal.

For some applications, it is desirable to use both a color image sensor and a near infrared image sensor. For example, in the automotive field, a system for the detection of objects around a vehicle can use a color image sensor which is particularly adapted for the detection of objects in daylight and an infrared sensor which is particularly adapted for the detection of objects in darkness. To minimize the space taken by the use of two image sensors and the total cost of such a detection system, it would be desirable to use a single image sensor capable of giving simultaneously signals representative of an image in the visible spectrum and signals representative of an image in the near infrared spectrum.

**SUMMARY OF THE INVENTION**

The present invention aims at an image sensor which is adapted to sense color images and near infrared images.

The present invention also aims at a method for providing, with a single image sensor, signals representative of the quantity of the visible spectrum light reaching the image sensor and signals representative of the quantity of near infrared light reaching the image sensor.

To attain these purposes and others, an embodiment of the present invention provides a near infrared/color photodetector made in a monolithic form in a lightly-doped substrate of a first conductivity type covering a holder and comprising a face on the side opposed to the holder. The photodetector comprises at least first and second photodiodes for the storage of electric charges photogenerated in the substrate, the second photodiode being adjacent to said face; and a first region located at least between the second photodiode and the holder, preventing the passage of said charges between a first substrate portion extending between said region and the holder and a second substrate portion extending between said face and the first region, the first photodiode being adapted to store at least charges photogenerated in the first substrate portion and the second photodiode being adapted to store charges photogenerated in the second substrate portion.

According to an embodiment of the present invention, the first photodiode is adjacent to said face and the first region is of the first conductivity type, more heavily doped than the substrate, the first region delimiting the second substrate portion at the level of the second photodiode and bordering a third substrate portion in which the first photodiode is located and which is in contact with the first substrate portion.

According to an embodiment of the present invention, the photodetector comprises at least a third photodiode adjacent to said face and a second region of the first conductivity type more heavily doped than the substrate, the second region being located under the third photodiode and delimiting a fourth substrate portion at the level of the third photodiode, and being also located at least between the first and second photodiodes, the first region extending under the second region and delimiting, with the second region, the second substrate portion in which the second photodiode is located, the first region, with the second region bordering the third substrate portion.

According to an embodiment of the present invention, the first region is more heavily doped than the second region.

According to an embodiment of the present invention, the second substrate portion has a first depth and the fourth substrate portion has a second depth inferior to the first depth.

According to an embodiment of the present invention, the first region is of a second conductivity type, the first photodiode being formed by the junction between the first substrate portion and the first region.

According to an embodiment of the present invention, the photodetector comprises at least a third photodiode adjacent to said face, the first region being located between the third photodiode and the holder.

According to an embodiment of the present invention, the photodetector comprises a second region of the second conductivity type linking the first region to said face.

According to an embodiment of the present invention, the photodetector comprises a stack of insulating and conductive layers covering said face, and at least a filter associated with the second photodiode which lets through light rays having wavelengths in a first range and in a second range superior to the first range, the second range including near infrared light wavelengths.

Another embodiment of the present invention provides a method for using the near infrared/color photodetector previously described, comprising the steps of providing a first signal representative of the charges stored in the first photodiode and a second signal representative of the charges stored in the second photodiode; and determining a corrected signal equal to the first signal diminished from the product of the second signal and a coefficient.

## BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.

Figure 1 shows schematically a partial section of an embodiment of a pixel of a near infrared/color image sensor;

Figure 2 shows an example of the evolution of the potential in the pixel of Fig. 1 along line A;

Figure 3 shows schematically a partial section of another embodiment of pixels of a near infrared/color image sensor;

Figure 4 is a circuit diagram of a first read and precharge circuit associated with the pixel of Fig. 1;

Figure 5 is a circuit diagram of a second read and precharge circuit associated with the pixel of Fig. 1;

Figure 6 shows schematically a partial section of another embodiment of pixels of a near infrared/color image sensor;

Figures 7 and 8 illustrate examples of arrangements of colored filters of the image sensor of Fig. 5;

Figures 9 to 13 illustrate light absorption properties of a common color image sensor;

Figure 14 shows a flow chart of an exemplary correction method of the signals provided by a near infrared/color image sensor; and

Figures 15 to 18 illustrate light absorption properties of a near infrared/color image sensor without and with the use of a correction method.

## DETAILED DESCRIPTION OF THE INVENTION

For clarity, the same elements have been designated with the same reference numerals in the different drawings.

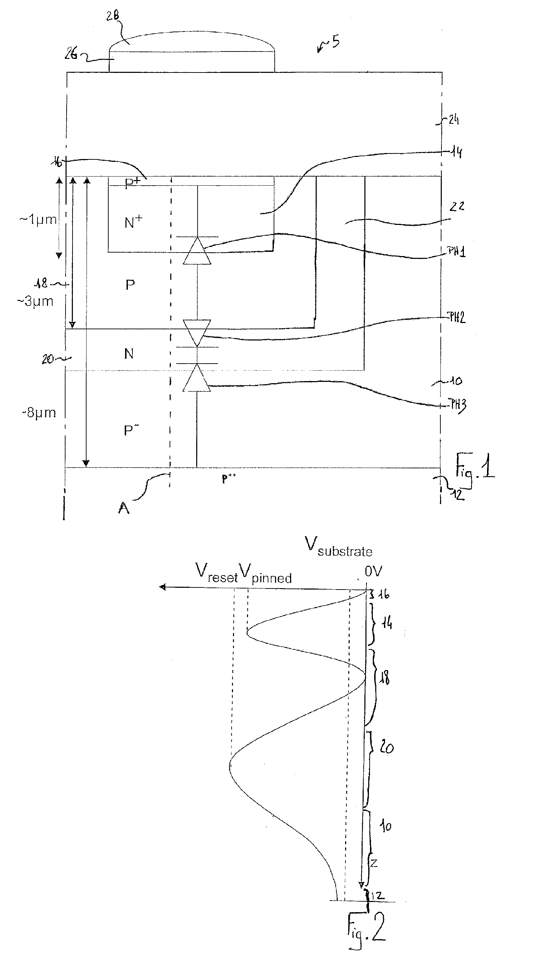

Fig. 1 is a partial simplified cross-section view of an embodiment in monolithic form of a pixel 5 of a near infrared/ color image sensor. The image sensor comprises, for example, an array of pixels, such as a pixel 5, arranged in rows and columns. The pixels are formed in a same active area of a semiconductor region 10, hereafter called the substrate, of a first conductivity type, for example, lightly-doped P-type (P$^-$). Substrate 10 corresponds for example to an epitaxial layer on a heavily-doped P-type silicon wafer 12 (P$^{++}$). The thickness of substrate 10 is preferably superior to 8 $\mu$m, for example, between 8 $\mu$m and 10 $\mu$m.

Pixel 5 comprises a first photodiode PH1 which comprises an active region 14 of the second conductivity type, for example heavily-doped N-type (N$^+$). Active region 14 is covered by an overlying heavily-doped P-type region 16 (P$^+$) and is located in a P-type region 18 (P), which is more heavily doped than substrate 10 but less heavily doped than region 16. Region 14 extends into substrate 10 to about 1 $\mu$m from the surface of substrate 10 and region 18 extends into substrate 10 to about 3 $\mu$m from the surface of substrate 10.

A region 20 of the second conductivity type (N) is located between photodiode PH1 and wafer 12 and separates region 18 from an underlying portion of substrate 10. Region 20 forms a second photodiode PH2 with region 18 and a third photodiode PH3 with the underlying portion of substrate 10. Region 20 is less heavily doped than region 14. A region 22 of the second conductivity type links region 20 to the surface of substrate 10.

Field insulation areas, not shown, for example silicon oxide regions ($SiO_2$) or highly-doped P-type regions, can be provided between adjacent pixels and/or between photodiode PH1 and region 22.

Substrate 10 is covered by a stack 24 of insulating layers, in which conductive tracks and vias for the connection of the different elements of the pixel are provided. A colored filter 26 is provided above stack 24. A microlens 28 covers colored filter 26. No filter which blocks infrared light is associated with the image sensor.

Figure 2 shows the evolution of the potential V in pixel 5 along line A which extends from the surface of substrate 10 and crosses successively regions 16, 14, 18, 20, 10 and 12.

In operation, heavily-doped P-type regions 16, 18 are constantly or nearly constantly maintained at a low reference voltage or ground, for example, 0 V. Moreover, wafer 12 is constantly or nearly constantly maintained at a voltage $V_{substrate}$ which can be equal to the low reference voltage or slightly superior thereto.

In the absence of light, active region 14 of photodiode PH1 reaches a so-called depletion quiescent level $V_{pinned}$ (positive) set by the sole features of the photodiode. Photodiode PH1 is of the so-called "totally depleted" type. Active region 20 is put to a reference level $V_{reset}$ (positive) by temporarily connecting region 22 to a high reference voltage source. Active regions 14 and 20 then form potential wells which fill according to the photodiode lighting, causing a decrease in the potential of regions 14 and 20. Indeed, when photons enter pixel 5, they cause the formation of electron-hole pairs. The holes are absorbed by wafer 12 or by the ground while the electrons are attracted by the potential wells present at the level of region 14 or 20 according to the location where the electron-hole pairs are formed. For this purpose, the doping profiles are selected so that active region 14, pinched between surface region 16 and underlying region 18, is depleted. The potential in the depletion state, that is, in the absence of radiation, is adjusted by the dopings of regions 16, 14 and 18 only. Moreover, the doping profiles are selected so that active region 20, pinched between region 18 and the underlying portion of substrate 10, is at least partially depleted.

Photons having a wavelength corresponding to colors blue, green, and red are absorbed down to depths respectively in the order of 1, 2 and 3 micrometers, and thus generate electron-hole pairs for which the electrons are mostly captured by the potential well at the level of region 14. The photons having a wavelength corresponding to near infrared and beyond are absorbed down to depths higher than 4 $\mu$m, and thus generate electron-hole pairs for which the electrons are captured by the potential well at the level of active region 14 or by the potential well at the level of active region 20 depending on the location of the generation of the electron-hole pairs.

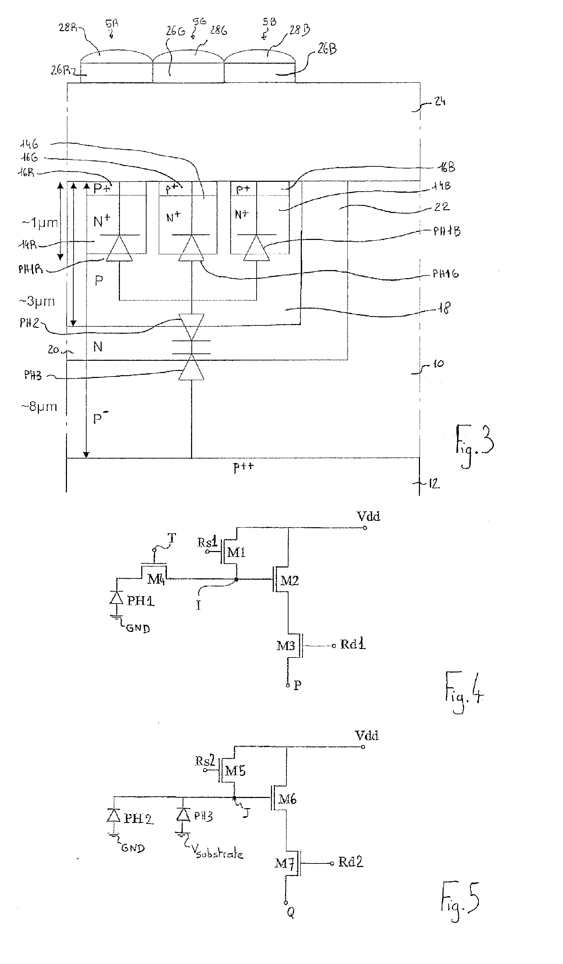

Figure 3 is a simplified cross-section view of part of another embodiment in monolithic form of a near infrared/color image sensor wherein the photodiodes PH2, PH3 are common to several adjacent pixels. For example, three adjacent pixels 5R, 5G, 5B associated with colors red, green and blue respectively are shown. Suffixes "R", "G" and "B" are added to references used in Fig. 1 in order to designate elements associated with pixel 5R, 5G, 5B respectively. The colored filters 26R, 26G, 26B only let through light rays having a wavelength corresponding to colors red, green and blue respectively and, as described previously, light rays having a wavelength corresponding to near infrared and beyond. Each pixel 5R, 5G, 5B comprises a photodiode PH1R, PH1G, PH1B having the same structure as photodiode PH1 in Fig. 1. Field insulation areas, not shown, for example, made of silicon oxide ($SiO_2$), can be provided between pixels 5R, 5G, 5B.

Figure 4 is a circuit diagram of a precharge and read device for photodiode PH1 of the pixel of Fig. 1. It can also be applied to each of photodiodes PH1R, PH1G and PH1B of Fig. 3. The precharge device is formed of an N-channel MOS transistor M1, interposed between a supply rail Vdd and a node I. The gate of precharge transistor M1 is capable of receiving a precharge control signal Rs1. The read device is formed of the series connection of two N-channel MOS transistors. The drain of a first one of these read transistors, called "M2" hereafter, is connected to supply rail Vdd. The source of second read transistor M3 is connected to input terminal P of an electronic processing circuit. The gate of first read transistor M2 is connected to node I. The gate of second read transistor M3 is capable of receiving a read signal Rd1. The anode of photodiode PH1 is connected to the ground GND of the circuit. The cathode of photodiode PH1 is connected to node I by a charge transfer N-channel MOS transistor M4. The gate of transfer transistor M4 is capable of receiving a charge transfer control signal T. It can be considered that a capacitor is present between node I and the ground GND, this capacitor resulting from parasitic capacitances of transistors M1, M2 and M4. Several photodiodes PH1 of adjacent pixels can be connected to a common node I by a corresponding transfer transistor M4.

Figure 5 is a circuit diagram of a precharge and read device for photodiodes PH2 and PH3 of the pixel of Fig. 1 or 2. The precharge device is formed of an N-channel MOS transistor M5, interposed between the supply rail Vdd and a node J. The gate of precharge transistor M5 is capable of receiving a precharge control signal Rs2. The cathodes of photodiodes PH2 and PH3 are connected to node J. The anode of photodiode PH2 is connected to the ground GND. The potential $V_{substrate}$ is applied to the anode of photodiode PH3. The read device is formed of the series connection of two N-channel MOS transistors. The drain of a first one of these read transistors, called M6 hereafter, is connected to supply rail Vdd. The source of second read transistor M7 is connected to input terminal Q of an electronic processing circuit. The gate of first read transistor M6 is connected to node J. The gate of second read transistor M7 is capable of receiving a read signal Rd2. We can consider that a capacitor is present between node J and the ground GND, this capacitor resulting from parasitic capacitances of the transistors M5 and M6. Several pairs of photodiodes PH2, PH3 can be connected to a common node J.

The operation of this circuit will now be described for a photodetection cycle for photodiode PH1 and for a photodetection cycle for photodiodes PH2 and PH3 which can be made simultaneously or independently. Similar photodetection cycles can be made for the photodiodes of the image sensor shown on Fig. 3.

A photodetection cycle for photodiode PH1 starts with a precharge phase during which a reference voltage level is applied to node I. This precharge is performed by maintaining read transistor M3 in an off state and by turning on precharge transistor M1. Once the precharge has been performed, precharge transistor M1 is turned off. Then, the system is maintained in this state, with all transistors being off. A given time after the end of the precharge, the voltage level at node I, that is, the real reference charge state of node I, is read. To evaluate the charge state, read transistor M3 is turned on for a very short time. The cycle carries on with a transfer to node I of the photogenerated charges, that is, the charges created and stored in the presence of radiation, in photodiode PH1. This transfer is performed by turning on transfer transistor M4. Once the transfer is over, transistor M4 is turned off and photodiode PH1 starts photogenerating and storing charges which will be subsequently transferred to node I again. Simultaneously, at the end of the transfer, the new charge state of node I is read. The output signal transmitted to terminal P then depends on the pinch of the channel of read transistor M2, which directly depends on the charge stored in the photodiode PH1.

A photodetection cycle for photodiodes PH2 and PH3 starts with a precharge phase during which a reference voltage level is applied to node J. This precharge is performed by maintaining read transistor M7 in an off state and by turning on precharge transistor M5. The precharge phase allows electrons to be evacuated from region 20 so that the potential of region 20 stabilizes to $V_{reset}$. Once the precharge has been performed, precharge transistor M5 is turned off. The state at node J is then read by turning on read transistor M7 for a very short time. After the closing of transistor M5, photodiodes PH2 and PH3 start storing charges leading to a diminution of the potential at node J. At the end of the transfer, the new charge state of node J is read. The output signal transmitted to terminal Q then depends on the pinch of the channel of read transistor M6, which directly depends on the charge stored in photodiodes PH2 and PH3.

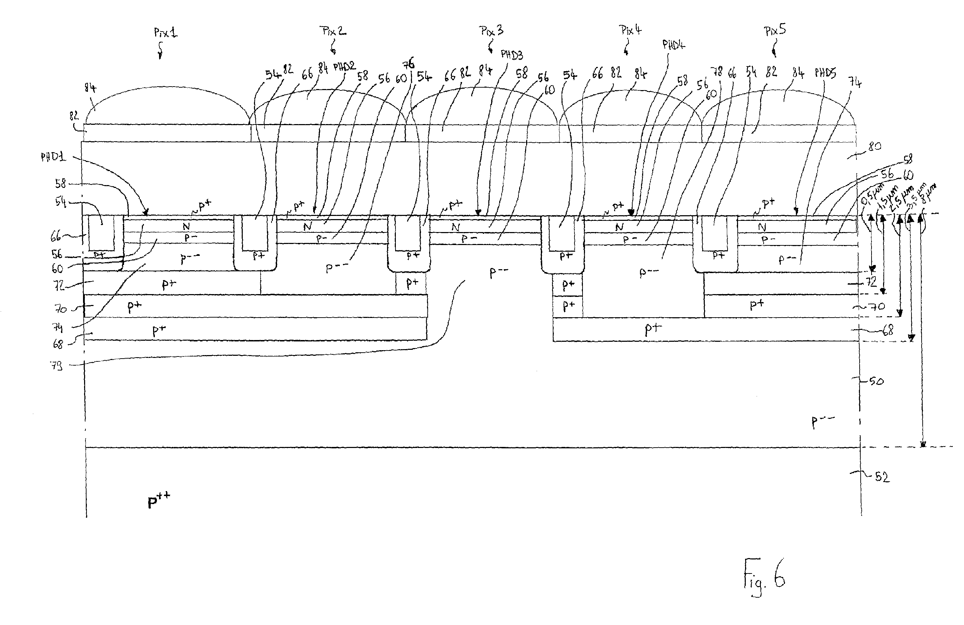

Figure 6 is a simplified cross-section view of part of another embodiment in monolithic form of a near infrared/color image sensor. By way of example, five pixels Pix1 to Pix5 of the image sensor are shown. Pixels Pix1 and Pix5 are associated with color blue, pixel Pix2 is associated with color green, pixel Pix4 is associated with color red and pixel Pix3 is associated with infrared. Each pixel Pix1 to Pix5 comprises a photodiode PHD1 to PHD5 which is formed in a same active area of a semiconductor region 50 of a first conductivity type, for example, lightly-doped P-type (P$^{--}$). Substrate 50 comprises for example an epitaxial layer on heavily-doped P-type silicon wafer 52 (P$^{++}$). Substrate 50 has a thickness of several micrometers, for example of 8 $\mu$m. The active areas associated with photodiodes PHD1 to PHD5 are delimited by field insulation regions 54, which is, for example made of silicon oxide (SiO$_2$). Each photodiode PHD1 to PHD5 comprises an active region 56 of the opposite conductivity type, for example, heavily-doped N-type (N). Active region 56 is interposed between an overlying heavily-doped P-type region 58 (P$^+$) and an underlying P-type region 60 (P$^-$), more heavily doped than substrate 50 but less heavily doped than region 58. Around each field insulation region 54 is provided a heavily-doped P-type region 66 (P$^+$) enabling the connection of region 58 to the reference voltage of the cell via substrate 50.

A heavily-doped P-type region 68 (P$^+$) formed at depths in the order of from 2.5 to 3.5 micrometers is provided, and substantially extends under all the circuit elements, except for the photodiodes associated with infrared, that is, photodiode PHD3 in Fig. 6. More precisely, region 68 extends at least under the photodiodes associated with color red, that is, photodiode PHD4 in Fig. 6, and possibly under the photodiodes associated with colors blue and green, that is, photodiodes PHD1, PHD2 and PHD5 in Fig. 6. Region 68 is, for example, formed by implantation with an energy of 2 Mev and a dose of $10^{17}$ atoms/cm$^2$. A heavily-doped P-type region 70 (P$^+$) formed at depths in the order of 1.5 to 2.5 micrometers is provided and substantially extends under all the circuit elements, except for the photodiodes associated with red and infrared, that is, photodiodes PHD4 and PHD3 in Fig. 6. More precisely, region 70 extends at least under the photodiodes associated with color green, that is, photodiode PHD2 in Fig. 6, and at least at the periphery of photodiodes associated with color red, that is, photodiode PHD4 in Fig. 6, and possibly under photodiodes associated with color blue, that is, photodiodes PHD1 and PHD5 in Fig. 6. Region 70 is, for example, formed by implantation with an energy of 1100-keV and a dose of $10^{13}$ to $10^{14}$ atoms/cm$^2$. A heavily-doped P-type region 72, which is formed at depths in the order of 0.5 to 1.5 micrometers, is provided and substantially extends under all the circuit elements, except for the photodiodes associated with green, red and infrared, that is, photodiodes PHD2, PHD4, and PHD3 in Fig. 6. More precisely, region 72 extends under at least the photodiodes associated with color blue, that is, photodiodes PHD1 and PHD5 in Fig. 6, and at least at the periphery of photodiodes associated with colors red and green, that is, photodiodes PHD4 and PHD2 in Fig. 6. Region 72 is, for example, formed by implantation with an energy of 550-keV and a dose of $10^{13}$ to $10^{14}$ atoms/cm$^2$. Regions 68, 70 and 72 form isolation cages at the level of each photodiode associated with colors red, green and blue and delimit a lightly-doped P-type portion 74 (P$^{--}$) of substrate 50 at the level of each photodiode associated with color blue (that is, photodiodes PHD1 and PHD5 in Fig. 6), a lightly-doped P-type portion 76 (P$^{--}$) of substrate 50, deeper than portion 74, at the level of each photodiode associated with color green (that is, photodiode PHD2 in Fig. 6), and a lightly-doped P-type portion 78 (P$^{--}$) of substrate 50, deeper than portion 76, at the level of each photodiode associated with color red (that is, photodiode PHD4 in Fig. 6). The lightly-doped P-type portion 79 of substrate 50 adjacent to photodiodes associated with infrared, that is photodiode PHD3 in Fig. 6, communicates directly with the rest of substrate 50 which extends between regions 68 and silicon wafer 52, under the pixels associated with colors red, green and blue.

Substrate 50 is covered by a stack 80 of insulating layers in which conductive tracks and vias for the connection of the different elements of the pixels are provided. For each pixel, a colored filter 82 is provided above stack 80 and a microlens 84 covers the colored filter 82. In particular, for pixel Pix3, the corresponding colored filter 82 can let through all visible and infrared light rays, that is to say filter 82 can be "transparent". Alternately, filter 82 can let through only the light rays having a wavelength superior to approximately 800 nm, that is to say filter 82 can be "black".

The structures of photodiodes PHD1 to PHD5 are similar to the structure of photodiode PH1 previously described in relation to Fig. 1. More precisely, in operation, the heavily-doped P-type regions 52, 58, 66, 68, 70 and 72 are constantly or nearly constantly maintained at the reference voltage or ground of the circuit, for example, 0 V. In the absence of light, active region 56 of each photodiode reaches a so-called depletion quiescent level (positive) set by the sole features of the photodiode. Active region 56 then forms of potential well which fills according to the photodiode lighting, causing a decrease in the voltage of region 56. Indeed, when photons enter a photodiode, they cause the formation of electron-hole pairs. The holes are absorbed by wafer 52 while the electrons are attracted by the potential well present at the level of region 56. Each photodiode PDH1 to PHD5 is of so-called totally depleted type to suppress any noise at the photodiode level. For this purpose, the doping profiles are selected so that active region 56, pinched between surface region 58 and underlying region 60, is depleted. The potential in the depletion state, that is, in the absence of radiation, is adjusted by the dopings of regions 56, 58, and 60 only.

This embodiment enables a local decrease of the voltage under each photodiode associated with colors red, green or blue at the level of underlying regions 68, 70 or 72. Thereby, when an electron is formed in one of lightly-doped P-type portions 74, 76, 78 located under a given photodiode associated with color red, green or blue, it is attracted towards increasing voltages, that is, towards N-type active region 56 of this same photodiode. Indeed, regions 68, 70 and 72 cause the formation of an electrostatic field which opposes to a displacement of such an electron towards a photodiode adjacent to the given photodiode. The present embodiment thus enables, by providing judiciously-distributed dopant concentration gradients, the formation of electrostatic fields which channel electron displacements towards the right photodiode. The applicant has shown that the greater the dopant concentration in regions 68, 70 and 72, the greater the obtained electrostatic fields, which further improves the electron channeling phenomenon.

The electrons which are generated in the lightly-doped P-type region 79 and in the portion of substrate 50 located between region 68 and wafer 52 are channeled towards the N-type active region 56 of the photodiode associated with infrared, which is the nearest. Indeed, regions 68, 70 and 72 cause the formation of an electrostatic field which opposes a displacement of such an electron towards photodiodes associated with colors red, green and blue. This means that an infrared photodiode collects electrons formed in associated portion 79 but also electrons formed in the portion of substrate 50 located under the photodiodes associated with colors red, green and blue. This enhances the sensitivity of the infrared pixels.

The precharge and read device associated with each of the photodiodes PHD1 to PHD5 can be identical to the device shown on Fig.4. However, common several transistors can be placed in between adjacent cells. More precisely, the photodiodes of adjacent pixels can be each connected to a common node I via an associated transfer transistor. The previously-described read method is then successively carried out for each photodiode of the pixels sharing a common node I.

According to a variation of the embodiment shown in Fig. 6, one or several regions among regions 68, 70, 72 can be replaced by two P-type regions substantially superposed, and having different dopant concentrations. More generally, one or several regions among regions 68, 70, 72 may correspond to stacks of several P-type regions obtained by implantations performed with different energies and doses.

According to a variation of the embodiment shown in Fig. 6, regions 68, 70 and 72 can be laterally shifted in a same direction with respect to what is shown on Fig. 6, region 68 being shifted more than region 70 and region 70 being shifted more than region 72. As a consequence, lightly-doped P-type portions 76, 78, 79 (P$^{--}$) delimited by regions 68, 70, 72 and associated with photodiodes PHD2, PHD4 and PHD3 respectively then have a generally inclined shape. This variation is adapted to the case where the light rays which reach the photodiodes are not perpendicular to the upper surface of the image sensor but are inclined with respect to the upper surface of the image sensor. Indeed, with the structure of Fig. 6, light rays reaching a given photodiode with a significant inclination risk causing the formation of electrons at the level of another region than the lightly-doped P-type portion 76, 78 and 79 (P$^{--}$) associated with the given photodiode, such electrons then risking being conveyed to another photodiode. The risk increases with the maximum travel length of the photon in substrate 50. This variation enables portions 76, 78 and 79 associated with the photodiodes to receive "green", "red" and "infrared" light rays which have a general inclination equal to the expected inclination of the light rays. Thereby, the formation of electrons is preferably obtained in the portion 76, 78 and 79 associated with each photodiode and such electrons are channeled to the corresponding photodiode by the electrostatic fields which are present, as described previously.

As an example, for an image sensor formed of an array of cells, the light rays which reach the cells located in the central region of the image sensor are generally perpendicular to the upper surface of the image sensor while the light rays which reach the cells located at the periphery of the image sensor are generally inclined with respect to the upper surface of the image sensor. In this case, the lateral shift of regions 76, 78 and 79 can advantageously depend on the position of the cell in the cell array and increase from the center to the periphery of the image sensor.

According to a variation of the embodiment shown in Fig. 6, it may be preferable to apply the previously-described structure associated with the photodiode receiving "red" light rays to the photodiode receiving "green" light rays, while the previously-described structure associated with the photodiode receiving "blue" or "green" light rays is applied to the photodiode receiving "red" light rays. In other words, according to such a variation, with respect to Fig. 6, the structure associated with photodiode PHD4 is applied to the photodiode receiving "green" light rays while the structure associated with photodiode PHD2 or PHD1 is applied to the photodiode receiving "red" light rays. Such a variation may be advantageous when the signals provided by the photodiodes receiving "green" light rays are desired to be prioritized, such signals being more critical for an image sensor. Indeed, according to such a variation, the substrate portion associated with the photodiode receiving "green" light rays is the deepest so that the capture of electrons by such a photodiode is favored.

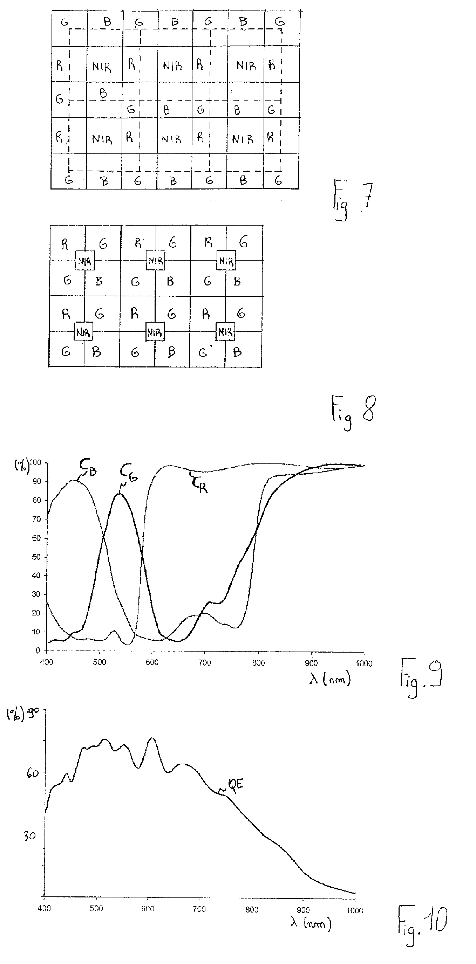

Figures 7 and 8 show partial simplified top views of two examples of arrangement of pixels of a near infrared/ color image sensor made in monolithic form. In these figures, a full line shows limits of pixels as seen from the top of the image sensor. References "R", "G", "B" and "NIR" respectively designate pixels associated with colors red, green, blue and with near infrared. In the example of Fig. 7, seen from the top of the image sensor, pixels correspond to squares having the same surface. Pixels are arranged in groups of four pixels having a common corner, green and near infrared pixels being provided on one diagonal and red and blue pixels being provided on the other diagonal. Dotted lines show the real portion of the substrate associated with each near infrared pixel. The real portion of the substrate associated with a near infrared pixel is bigger than the portion of substrate associated with a color pixel and corresponds approximately to the surface of four color pixels. In the example of Fig. 8, seen from the top of the image sensor, the surfaces of pixels for colors red, green and blue are identical and the surface of a near infrared pixel is smaller. Each near infrared pixel is rounded by four color pixels: a red pixel, a blue pixel and two green pixels. A high proportion of the electrons coming from near infrared light rays are generated in the portion of substrate 50 located under the color pixels on Fig. 8, and thus the real portion of substrate associated with a near infrared pixel NIR on Fig. 8 is nearly equivalent to the one of Fig. 7. The size of the pixel seen from the top of the image sensor is mostly determined by the size of photodiode PHD3 necessary to obtain a correct storage of the generated electrons.

Hereafter is described a common method for the treatment of the signals provided by the read devices of the pixels of a color image sensor.

Figure 9 shows as a percentage the evolution of the transmitted light rays crossing through a colored filter according to the wavelength ($\lambda$) of the light rays. Curves $C_B$, $C_G$ and $C_R$ refer to colored filters which let through the light rays associated to color blue, green and red respectively. As can be seen from this figure, the colored filters are not perfect and each colored filter associated with a determined color partially lets through light rays associated with another color. Moreover, each colored filter also almost completely lets through the infrared light rays having a wavelength superior to approximately 800 nm.

Figure 10 shows a curve QE of the evolution, as a percentage, of the proportion of the light rays reaching the image sensor (with no colored filters) which actually lead to the generation of electrons absorbed by the photodiodes of the image sensor, according to the wavelength ($\lambda$) of the light rays. Such a parameter is generally called quantum efficiency. The curve QE shows diminutions of the generation of electrons for light rays having a low wavelength (around color blue) and a high wavelength (near infrared and beyond). These diminutions are due to two different phenomena. Firstly, the different elements covering the substrate of the image sensor (insulating layers, conductive tracks, polysilicon tracks, etc.) tend to absorb or reflect color light rays with a low wavelength (around color blue) which then do not reach the substrate. The proportion of absorption of light rays in a silicon substrate per micrometer of the thickness of the substrate decreases as the wavelength increases. This means that for a substrate having a given thickness, the total percentage of the light rays absorbed in the substrate, and leading to the generation of electrons captured by the photodiodes of the image sensor, decreases as the wavelength increases. The curve QE of Fig. 10 is given for a substrate having a thickness of about 8 micrometers.

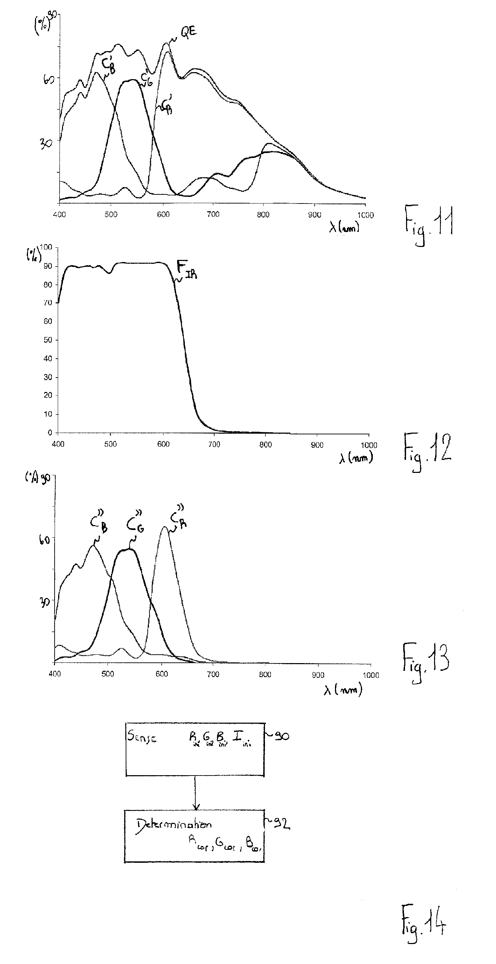

Figure 11 shows as a percentage the evolution of the proportion of light rays reaching the image sensor covered with colored filters which actually lead to the generation of electrons absorbed by the photodiodes of the pixel, according to the wavelength ($\lambda$) of the light rays. Curves $C_B'$, $C_G'$ and $C_R'$ refer respectively to blue, green and red pixels. Curve QE is also shown on Fig. 11. As can be seen from this figure, a non-negligible number of electrons issued from infrared light rays (having a wavelength superior to 750 nm) are generated in the blue, green and red pixels. That is why a separate infrared filter must be used with a common color image sensor.

Figure 12 shows a curve $F_{1R}$ of evolution, as a percentage, of the transmission of light rays crossing through an infrared filter according to the wavelength ($\lambda$) of the light rays. As it can be seen from this figure, the infrared filter has a rather abrupt cut at about 680 nm but also has attenuation of at least about 10 % for wavelengths inferior to 680 nm.

Figure 13 shows as a percentage the evolution of the proportion of light rays reaching a color image sensor having colored filters and an infrared filter which actually lead to the generation of electrons absorbed by the photodiodes of the pixels, according to the wavelength ($\lambda$) of the light rays. Curves $C_B''$, $C_G''$ and $C_R''$ refer respectively to blue, green and red pixels. As it can be seen, there is no longer a contribution from light rays having a wavelength superior to 750 nm. However, for each pixel of a given color, there is a non-negligible contribution of the light rays of the other colors. That is why compensation or correction is generally applied on the signals provided by the read devices associated with the pixels, each read device providing a signal representative of the quantity of electrons captured by the photodiode of the associated pixel.

By way of example, if we call $R_{ini}$, $G_{ini}$ and $B_{ini}$ the useful signals provided by adjacent pixels associated with colors red, green and blue respectively, a compensation matrix M is used to obtain corrected signals $R_{cor}$, $G_{cor}$ and $B_{cor}$ according to the following relation:

$$\begin{bmatrix} R_{cor} \\ G_{cor} \\ B_{cor} \end{bmatrix} = M \begin{bmatrix} R_{ini} \\ G_{ini} \\ B_{ini} \end{bmatrix} = \begin{bmatrix} C_{rr} & C_{rg} & C_{rb} \\ C_{gr} & C_{gg} & C_{gb} \\ C_{br} & C_{bg} & C_{bb} \end{bmatrix} \begin{bmatrix} R_{ini} \\ G_{ini} \\ B_{ini} \end{bmatrix} \qquad (1)$$

Generally, the coefficients on the diagonal of matrix M are equal to "1" and the other coefficients are negative, which means that a part of the signals of the other colors is subtracted from each signal $R_{ini}$, $G_{ini}$, $B_{ini}$ of a given color. The determination of the coefficients of compensation matrix M is generally made based on images with calibrated colors.

Such a compensation can no longer be used for a near infrared/color image sensor. Indeed, since no infrared filter is associated with the image sensors, the contribution of the infrared light rays has to be taken into account for the color pixels. However, for the near infrared pixel, a high resolution is usually not needed with the signal $I_{ini}$ provided by the photodiode of the near infrared pixel so that no compensation can be made on this signal.

Figure 14 shows a flow chart of an example of compensation or correction of the signals provided by color pixels of a near infrared/color image sensor. The compensation method can be applied to the embodiments of near infrared/color image sensors shown on Figs. 1, 3 and 6 and more generally to any kind of near infrared/color image sensor which requires compensation.

At step 90, the signals $R_{ini}$, $G_{ini}$, $B_{ini}$, $I_{ini}$ provided by adjacent pixels are collected.

At step 92, new signals $R_{cor}$, $G_{cor}$, $B_{cor}$ are determined using a compensation matrix M'.

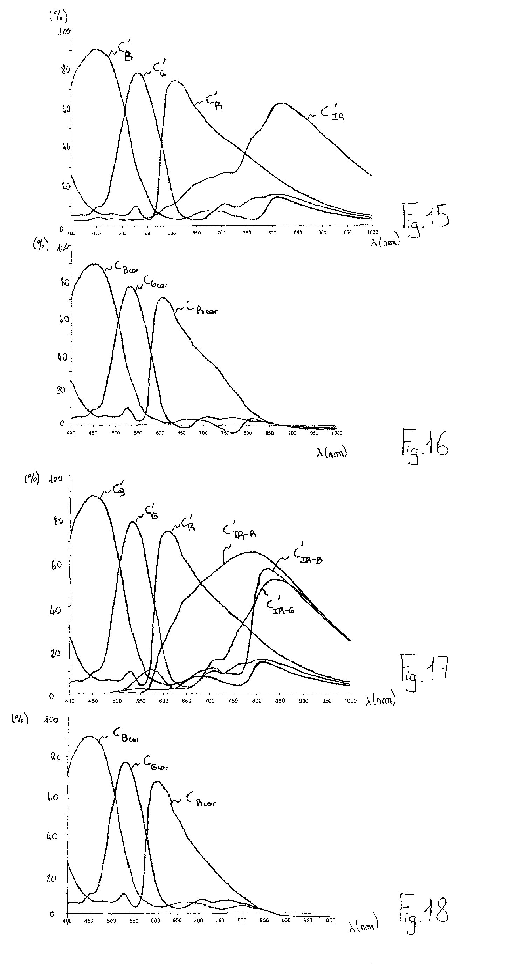

Figure 15 is a figure similar to Fig. 11 and is obtained by simulation with the image sensor of Fig. 6. Curve $C_{IR}'$ shows as a percentage the evolution of the proportion of light rays reaching the near infrared pixel which actually lead to the generation of electrons absorbed by the photodiode of the pixel, according to the wavelength ($\lambda$) of the light rays. In the present simulation, the filter associated with the near infrared pixel does not let through, at least partially, the color light rays. Moreover, the attenuation at the low wavelengths due to the elements covering the substrate, as described previously, was not taken into account for the simulation. As it can be seen from this figure, there is a contribution by the infrared light rays to each signal provided by a color pixel.

For the embodiment shown on Fig. 6, an infrared signal $I_{ini}$ is obtained for three color signals $R_{ini}$, $G_{ini}$ and $B_{ini}$. The compensation matrix M' is obtained according to the following relation:

$$\begin{bmatrix} R_{cor} \\ G_{cor} \\ B_{cor} \end{bmatrix} = M' \begin{bmatrix} R_{ini} \\ G_{ini} \\ B_{ini} \\ I_{ini} \end{bmatrix} = \begin{bmatrix} C_{rr} & C_{rg} & C_{rb} & C_{ri} \\ C_{gr} & C_{gg} & C_{gb} & C_{gi} \\ C_{br} & C_{bg} & C_{bb} & C_{bi} \end{bmatrix} \begin{bmatrix} R_{ini} \\ G_{ini} \\ B_{ini} \\ I_{ini} \end{bmatrix} \qquad (2)$$

With the exemplary following compensation matrix M':

$$M' = \begin{bmatrix} 1 & 0 & 0 & -0.27 \\ 0 & 1 & 0 & -0.21 \\ 0 & 0 & 1 & -0.18 \end{bmatrix} \qquad (3)$$

the obtained corrected color signals $R_{cor}$, $G_{cor}$ and $B_{cor}$ are the signals which would be obtained with an image sensor having the curves $C_{Bcor}$, $C_{Gcor}$ and $C_{Rcor}$ shown of Fig. 16. By way of example, each coefficient $C_{ri}$, $Cgi$ and $C_{bi}$ of matrix M' can correspond to the ratio of the integral of curve $C'_{IR}$ between wavelengths 800 and 1000 nm and the integral of curve $C'_B$, $C'_G$ or $C'_R$ between wavelengths 800 and 1000 nm. As it can be seen from Fig. 16, for each color pixel, the contribution of the infrared light rays has been suppressed. Of course, compensation must also be made for each signal $R_{ini}$, $G_{ini}$, $B_{ini}$ to suppress for each color pixel the contribution of the other visible colors as described previously. This compensation of the contribution of infrared light can also be applied to the image sensor of Fig. 3.

Figure 17 is a figure similar to Fig. 15 and is obtained by simulation with the image sensor of Fig. 1. In this embodiment, for each color pixel, there is an associated near infrared pixel. Curves $C_{IR-R'}$, $C_{IR-G'}$ and $C_{IR-B'}$ show as a percentage the evolution of the proportion of light rays reaching the near infrared pixel associated respectively to a red, green and blue pixel which actually lead to the generation of electrons absorbed by the photodiode of the near infrared pixel, according to the wavelength ($\lambda$) of the light rays. The compensation matrix M' is obtained from the following relation:

$$\begin{bmatrix} R_{cor} \\ G_{cor} \\ B_{cor} \end{bmatrix} = M' \begin{bmatrix} R_{ini} \\ G_{ini} \\ B_{ini} \\ I_R \\ I_G \\ I_B \end{bmatrix} = \begin{bmatrix} C_{rr} & C_{rg} & C_{rb} & C_{ri-r} & C_{ri-g} & C_{ri-b} \\ C_{gr} & C_{gg} & C_{gb} & C_{gi-r} & C_{gi-g} & C_{gi-b} \\ C_{br} & C_{bg} & C_{bb} & C_{bi-r} & C_{bi-g} & C_{bi-b} \end{bmatrix} \begin{bmatrix} R_{ini} \\ G_{ini} \\ B_{ini} \\ I_R \\ I_G \\ I_B \end{bmatrix} \quad (4)$$

where $I_R$, $I_G$ and $I_B$ are the signals provided by the near infrared pixels associated with the red, green and blue pixels respectively. With the exemplary following compensation matrix M':

$$M' = \begin{bmatrix} 1 & 0 & 0 & -0.28 & 0 & 0 \\ 0 & 1 & 0 & 0 & -0.23 & 0 \\ 0 & 0 & 1 & 0 & 0 & -0.19 \end{bmatrix} \quad (5)$$

the corrected color signals $R_{cor}$, $G_{cor}$ and $B_{cor}$ are the signals which would be obtained with an image sensor having the curves $C_{Bcor}$, $C_{Gcor}$ and $C_{Rcor}$ shown on Fig. 18.

For the embodiment of Fig.1, instead of using signals $I_R$, $I_G$ and $I_B$, a single infrared signal could be used corresponding to the average of signals $I_R$, $I_G$ and $I_B$. In this case, compensation matrix M' can be given by relation (2).

Of course, the present invention is likely to have various alterations, modifications, and improvements which will readily occur to those skilled in the art. In particular, it will be within the abilities of those skilled in the art to adjust the doping levels and types to the desired performances and the particular materials used according to the constraints of a specific manufacturing technology.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. A near infrared/color photodetector made in a monolithic form in a lightly-doped substrate (10; 50) of a first conductivity type covering a holder (12; 52) and comprising a face on the side opposed to the holder, the photodetector comprising:

   at least first and second photodiodes for the storage of electric charges photogenerated in the substrate, the second photodiode (PH1; PH1R; PHD4) being adjacent to said face; and
   a first region (20; 68) located at least between the second photodiode and the holder, preventing the passage of said charges between a first substrate portion extending between said region and the holder and a second substrate portion (18; 78) extending between said face and the first region, the first photodiode (PH3; PHD3) being adapted to store at least charges photogenerated in the first substrate portion and the second photodiode being adapted to store charges photogenerated in the second substrate portion.

2. The photodetector of claim 1, wherein the first photodiode (PHD3) is adjacent to said face and wherein the first region (68) is of the first conductivity type, more heavily doped than the substrate (50), the first region delimiting the second substrate portion (78) at the level of the second photodiode (PHD4) and bordering a third substrate portion (79) in which the first photodiode (PHD3) is located and which is in contact with the first substrate portion.

3. The photodetector of claim 2, comprising at least a third photodiode (PHD2) adjacent to said face and a second region (70, 72) of the first conductivity type more heavily doped than the substrate, the second region (70, 72) being located under the third photodiode and delimiting a fourth substrate portion (74, 76) at the level of the third photodiode, and being also located at least between the first and second photodiodes (PHD3, PHD4), the first region (68) extending under the second region and delimiting, with the second region, the second substrate portion (78) in which the second photodiode (PHD4) is located, the first region, with the second region bordering the third substrate portion (79).

4. The photodetector of claim 3, wherein the first region (68) is more heavily doped than the second region (70, 72).

5. The photodetector of claim 3, wherein the second substrate portion (78) has a first depth and the fourth substrate portion (74, 76) has a second depth inferior to the first depth.

6. The photodetector of claim 1, wherein the first region (20) is of a second conductivity type, the first photodiode (PH3) being formed by the junction between the first substrate portion and the first region.

7. The photodetector of claim 6, comprising at least a third photodiode (PH1B, PH1G) adjacent to said face, the first region (20) being located between the third photodiode and the holder (12).

8. The photodetector of claim 6, comprising a second region (22) of the second conductivity type linking the first region (20) to said face.

9. The photodetector of claim 1, comprising a stack of insulating and conductive layers (24; 80) covering said face, and at least a filter (26; 26R; 82) associated with the second photodiode (PH1; PH1R; PHD4) which lets through light rays having wavelengths in a first range and in a second range superior to the first range, the second range including near infrared light wavelengths.

10. A method for using the near infrared/color photodetector of claim 1, comprising the following steps:

providing a first signal ($I_{ini}$) representative of the charges stored in the first photodiode (PH3; PHD3) and a second signal ($B_{ini}$, $G_{ini}$, $R_{ini}$) representative of the charges stored in the second photodiode (PH1; PH1R; PHD4); and

determining a corrected signal equal to the first signal diminished from the product of the second signal and a coefficient.

28

26

5

24

14

16

P⁺

N⁺

~1µm

22

PH1

18

P

~3µm

PH2

20

N

10

~8µm

P⁻

PH3

A

P⁺⁺

12

Fig. 1

$V_{substrate}$

$V_{reset}$ $V_{pinned}$ 0V

16

14

18

20

10

z

12

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Europäisches
Patentamt

European
Patent Office

Office européen
des brevets

**EUROPEAN SEARCH REPORT**

Application Number

EP 08 30 5733

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 100 863 497 B (MARU LSI CO LTD [KR]) 14 October 2008 (2008-10-14) | 1,6-10 | INV. H01L27/146 |
| A | * abstract * <br> * paragraph [0027] - paragraph [0044] * <br> * paragraph [0052] * <br> * figures 2,3,5 * | 2-5 | |
| E | & US 2008/315104 A1 (NAM JUNG HYUN [KR]) 25 December 2008 (2008-12-25) <br> * paragraph [0027] - paragraph [0044] * <br> * paragraph [0052] * <br> * figures 2,3,5 * | 1-10 | |
| | ----- | | |
| X | EP 1 630 871 A (MATSUSHITA ELECTRIC IND CO LTD [JP]) 1 March 2006 (2006-03-01) | 1,6,8 | |
| Y | * paragraph [0032] - paragraph [0037] * | 2-5 | |
| A | * paragraph [0039] - paragraph [0047] * <br> * claim 10; figures 2,4-8 * | 7,9,10 | |
| | ----- | | |
| X | US 2008/087922 A1 (HYNECEK JAROSLAV [US]) 17 April 2008 (2008-04-17) | 1 | |
| Y | * paragraph [0017] - paragraph [0027] * | 2-5 | TECHNICAL FIELDS SEARCHED (IPC) |
| A | * figure 2 * | 6-9 | H01L |
| | ----- | | |
| X | US 2008/067330 A1 (YAMAMOTO ATSUSHI [JP]) 20 March 2008 (2008-03-20) | 1,6,8 | |
| A | * page 84 * <br><br> * page 106 - page 118 * <br> * figures 10A,17 * | 2-5,7,9, 10 | |
| | ----- | | |
| X | US 5 801 373 A (OOZU HAYAO [JP] ET AL) 1 September 1998 (1998-09-01) | 1,6,8 | |
| A | * column 6, line 44, paragraph 50 * <br> * column 8, line 33, paragraph 42 * <br> * column 9, line 6, paragraph 28 * <br> * column 16, line 66 - column 17, line 1 * <br> * figures 1,5,7,40 * | 2-10 | |
| | ----- | | |

-/--

The present search report has been drawn up for all claims

| Place of search | Date of completion of the search | Examiner |
|---|---|---|
| Munich | 17 June 2009 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 08 30 5733

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2002/063302 A1 (FURUMIYA MASAYUKI [JP] ET AL) 30 May 2002 (2002-05-30)<br>* paragraph [0054] *<br>* paragraph [0058] *<br>* figures 4-6 *<br>----- | 1-9 | |

TECHNICAL FIELDS
SEARCHED      (IPC)

The present search report has been drawn up for all claims

| Place of search | Date of completion of the search | Examiner |
|---|---|---|
| Munich | 17 June 2009 | Kostrzewa, Marek |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 08 30 5733

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2009

| Patent document cited in search report | | Publication date | Patent family member(s) | | Publication date |
|---|---|---|---|---|---|
| KR 100863497 | B | 14-10-2008 | US 2008315104 A1 | | 25-12-2008 |
| US 2008315104 | A1 | 25-12-2008 | KR 100863497 B1 | | 14-10-2008 |
| EP 1630871 | A | 01-03-2006 | CN 1723564 A | | 18-01-2006 |
| | | | JP 2005143038 A | | 02-06-2005 |
| | | | WO 2005045936 A1 | | 19-05-2005 |
| | | | US 2006114551 A1 | | 01-06-2006 |
| US 2008087922 | A1 | 17-04-2008 | CN 101162724 A | | 16-04-2008 |
| | | | JP 2008098601 A | | 24-04-2008 |
| | | | KR 100821469 B1 | | 11-04-2008 |
| US 2008067330 | A1 | 20-03-2008 | NONE | | |
| US 5801373 | A | 01-09-1998 | NONE | | |
| US 2002063302 | A1 | 30-05-2002 | DE 10160501 A1 | | 12-09-2002 |
| | | | JP 2002170945 A | | 14-06-2002 |
| | | | KR 20020042508 A | | 05-06-2002 |
| | | | TW 517388 B | | 11-01-2003 |

EPO FORM P0459

For more details about this annex : see Official Journal of the European Patent Office, No. 12/82